# FASCICULE DE BREVET EUROPEEN

(11) **EP 2 712 756 B1**
(45) Date de publication et mention de la délivrance du brevet: **13.04.2016**
(21) Numéro de dépôt: 13186491.0
(22) Date de dépôt: 27.09.2013
(51) Int. Cl.: B60K 37/06, H01H 13/702, H03K 17/975, H03K 17/96, H01H 3/02

(54) **Module de commande**
Steuermodul
Control module

(30) Priorité: 27.09.2012 FR 1202577
(43) Date de publication de la demande: 02.04.2014
(73) Titulaire: Valeo Systemes Thermiques, 78320 Le Mesnil Saint Denis (FR)
(72) Inventeur: Huynh, Tan Duc, 93330 Neuilly sur Marne (FR)
(74) Mandataire: Pothmann, Karsten

(56) Documents cités:
- EP-A1- 2 372 914
- DE-A1-102008 031 743
- GB-A- 2 416 338
- US-B1- 7 489 303

## Description

Les modes de réalisation de la présente invention concernent un module de commande des équipements d'un véhicule automobile.

Il est connu dans l'état de la technique d'utiliser des capteurs capacitifs pour détecter la présence d'un doigt d'un utilisateur dans une zone prédéfinie et appliquer une commande associée à cette zone prédéfinie créant ainsi une touche de commande capacitive. De telles touches capacitives permettent de remplacer les boutons-poussoirs traditionnels tout en améliorant l'esthétique puisque les capteurs capacitifs peuvent être intégrés dans un module de commande dont la surface extérieure est lisse.

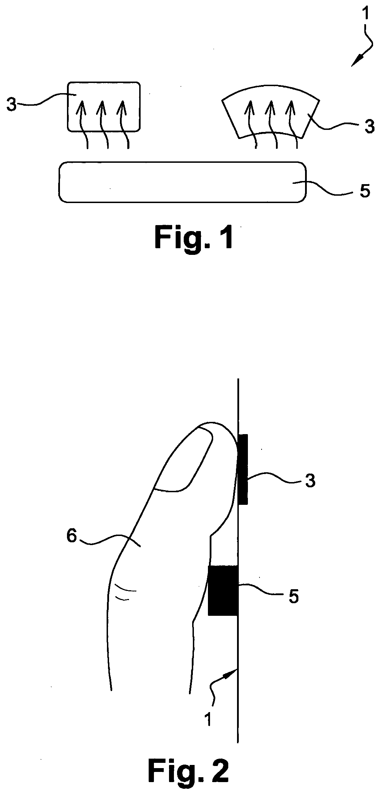

Cependant, afin de repérer la zone correspondant aux touches capacitives et agrémenter une surface toute lisse, les constructeurs automobiles ajoutent des décorations périphériques et notamment des décorations en relief. Ces décorations, dans le cadre de notre invention sont électriquement conductrices. A titre d'exemple non limitatif, ces décorations sont métalliques, telles que par exemple des décorations chromées.. La figure 1 représente un exemple d'un module de commande 1 comprenant deux touches capacitives 3 repérées par des symboles correspondant aux fonctions associées aux touches capacitives 3 et une décoration électriquement conductrice 5 sous la forme d'une bande située juste au-dessous des touches capacitives. L'inconvénient de ces décorations électriquement conductrices 5 est le fait que lorsque le doigt 6 d'un utilisateur vient activer une touche capacitive 3, il peut se retrouver par mégarde en contact avec la décoration électriquement conductrice 5 comme représenté sur la figure 2. Ce contact avec la décoration électriquement conductrice 5 tend à perturber les capteurs capacitifs associés aux touches capacitives 3. En effet, le contact entre le doigt 6 et la décoration électriquement conductrice 5 crée une capacité parasite de sorte que la présence du doigt 6 au niveau de la touche capacitive 3 peut ne pas être détectée.

Il apparaît donc nécessaire de surmonter au moins partiellement les inconvénients précités de l'état de la technique et de proposer un équipement permettant de réduire l'influence d'une décoration électriquement conductrice sur la sensibilité d'un capteur capacitif.

Ainsi, les modes de réalisation de la présente invention concernent un module de commande comprenant
- au moins un capteur capacitif configuré pour détecter un changement de capacité correspondant à un premier seuil de détection associé à la présence d'un doigt d'un utilisateur dans une première zone prédéfinie correspondant à une touche de commande,
- un élément électriquement conducteur situé dans une deuxième zone prédéfinie qui est distincte de la première zone prédéfinie et qui est dans un périmètre correspondant à la taille d'un doigt autour de la première zone,
le module comprend également,
- un capteur capacitif supplémentaire couplé à l'élément électriquement conducteur, configuré pour détecter la présence d'un doigt d'un utilisateur sur l'élément électriquement conducteur,
- des moyens de contrôle du seuil de détection du, au moins un, capteur capacitif associé à une touche de commande configurés pour appliquer un deuxième seuil de détection lorsqu'un doigt d'un utilisateur est détecté sur l'élément électriquement conducteur par le capteur capacitif supplémentaire.

Selon un autre aspect de la présente invention, le deuxième seuil de détection est déterminé à partir du changement de capacité produit par la présence d'un doigt d'un utilisateur à la fois sur la touche de commande et sur l'élément électriquement conducteur.

Selon un aspect supplémentaire de la présente invention, le deuxième seuil de détection correspond à une détection plus sensible que la détection fournie par le premier seuil de détection.

Selon un aspect additionnel de la présente invention, le module de commande comprend au moins un premier et un deuxième capteurs capacitifs associés à une première et une deuxième zones de détection prédéfinies correspondant à une première et une deuxième touches de commande et dans lequel l'élément électriquement conducteur est situé dans un périmètre correspondant à la taille d'un doigt autour de la première et de la deuxième zone de détection prédéfinie.

Selon un autre aspect de la présente invention, l'élément électriquement conducteur comprend du chrome.

Selon un aspect supplémentaire de la présente invention, le module de commande comprend un film extérieur sur lequel est disposé l'élément électriquement conducteur et sur lequel l'utilisateur pose le doigt pour activer la, au moins une, touche de commande.

Selon un autre aspect de la présente invention, le module de commande comprend une façade en polycarbonate et dans lequel le film extérieur est fixé sur la face extérieure de ladite façade.

Selon un aspect supplémentaire de la présente invention, l'électrode du capteur capacitif associé à la, au moins une, touche de commande et l'électrode du capteur capacitif supplémentaire sont disposées dans un film capacitif, ledit film capacitif étant fixé sur la face intérieure de la façade.

Selon un aspect additionnel de la présente invention, la fixation du film extérieur et du film capacitif sur la façade est réalisée par collage.

Selon un autre aspect de la présente invention, le module de commande comprend un microcontrôleur connecté à l'électrode du capteur capacitif associé à la, au moins une, touche capacitive et à l'électrode du capteur capacitif supplémentaire, le microcontrôleur étant configuré pour réaliser les mesures capacitives et comprenant les moyens de contrôle du seuil de détection de la, au moins une, touche de commande.

D'autres caractéristiques et avantages de l'invention apparaîtront dans la description qui va maintenant en être faite, en référence aux dessins annexés qui en représentent à titre indicatif mais non limitatif, un mode de réalisation possible.

Sur ces dessins :
- La figure 1 représente une vue de face d'un module de commande comprenant deux touches capacitives et un élément électriquement conducteur;
- La figure 2 représente une vue latérale d'un doigt en contact avec un module de commande comprenant une touche capacitive et un élément électriquement conducteur;
- La figure 3 représente un schéma de la structure d'un module de commande selon un mode de réalisation de la présente invention ;
- La figure 4 représente un schéma d'un module de commande comprenant trois touches capacitives et un élément électriquement conducteur étendu selon une première forme ;
- La figure 5 représente un schéma des capteurs capacitifs du module de commande de la figure 4 ;
- La figure 6 représente un schéma d'un module de commande comprenant trois touches capacitives et un élément électriquement conducteur étendu selon une deuxième forme ;
- La figure 7 représente un schéma des capteurs capacitifs du module de commande de la figure 6 ;

Les modes de réalisation de la présente invention concernent un module de commande comprenant au moins une touche de commande capacitive associée à un capteur capacitif et au moins un élément électriquement conducteur situé à proximité de la touche de commande capacitive dans lequel un capteur capacitif supplémentaire est couplé à l'élément électriquement conducteur pour détecter la présence d'un doigt d'un utilisateur sur l'élément électriquement conducteur. La sensibilité du capteur capacitif associé à la touche capacitive est alors modifiée pour prendre en compte la capacité parasite produite par la présence du doigt sur la décoration électriquement conductrice.

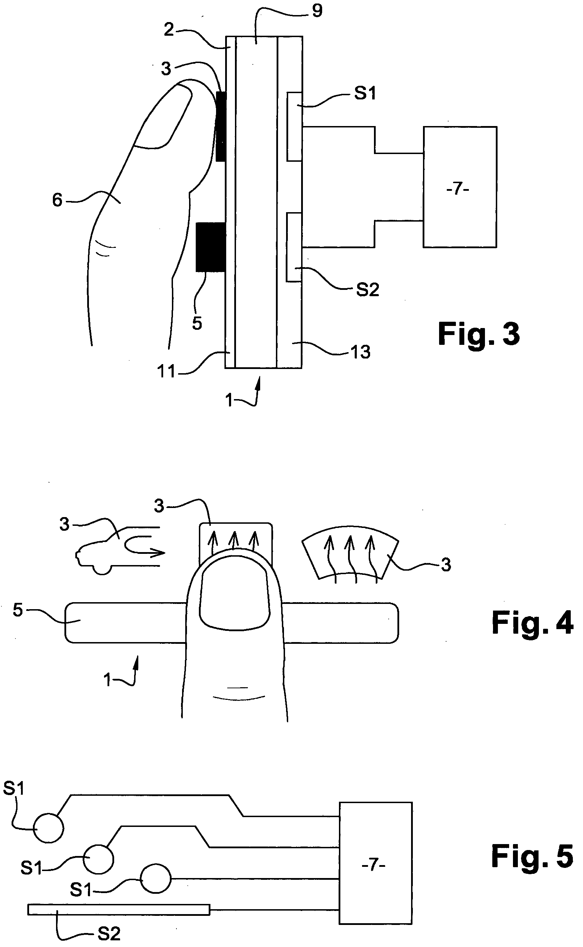

La figure 3 représente un exemple d'un module de commande 1 comprenant un capteur capacitif S1 configuré pour détecter un changement de capacité correspondant à la présence d'un doigt 6 d'un utilisateur dans une première zone prédéfinie de la surface extérieure 2 du module de commande 1 correspondant à l'emplacement d'une touche de commande capacitive 3 et placée en regard du capteur capacitif S1. La zone prédéfinie de la touche de commande capacitive 3 correspond à l'emplacement d'un symbole associé à la touche de commande 3.

Le module de commande 1 comprend également un élément électriquement conducteur de décoration 5, par exemple en chrome, situé en dehors de la zone prédéfinie de la touche de commande 3 mais dans un périmètre correspondant à la taille d'un doigt de sorte qu'un utilisateur est capable de toucher à la fois la touche de commande capacitive 3 et l'élément électriquement conducteur 5 avec un seul doigt. De plus, si la décoration est éloignée de plus de quelques centimètres, par exemple plus de deux centimètres, de la touche de commande capacitive 3, son influence sur la capteur capacitif S1 associé à la touche de commande capacitive 3 est alors négligeable.

Le module de commande comprend également un capteur capacitif supplémentaire S2 placé en regard de l'élément électriquement conducteur 5 et configuré pour détecter la présence d'un doigt 6 d'un utilisateur sur l'élément électriquement conducteur 5. Le capteur capacitif S1 associé à la touche de commande capacitive 3 et le capteur capacitif supplémentaire S2 couplé à l'élément électriquement conducteur 5 sont reliés à des moyens de traitement 7, comme par exemple un microcontrôleur, configurés pour traiter les signaux issus des différents capteurs S1, S2 et réaliser les mesures capacitives. Les capteurs capacitifs S1, S2 comprennent une électrode de détection dont la capacitance par rapport à la masse varie en fonction de la présence d'un doigt 6 d'un utilisateur.

La détection capacitive se fait, par exemple, en chargeant la capacité à mesurer par une tension fixe au travers d'une résistance. Un compteur d'impulsions mesure le temps qui s'écoule entre le début de charge et l'atteinte d'un seuil de tension prédéterminé. Cependant, d'autres techniques de mesure de capacité connues de l'état de la technique peuvent également être utilisées pour mesurer les variations de capacité au niveau des capteurs capacitifs S1 et S2.

Les moyens de traitement sont donc configurés d'une part pour détecter la présence du doigt 6 de l'utilisateur au niveau de l'élément électriquement conducteur 5 grâce au capteur supplémentaire S2 et d'autre part pour détecter la présence du doigt 6 de l'utilisateur au niveau de la touche de commande capacitive 3 grâce au capteur capacitif S1. Pour cela, un premier seuil de détection est appliqué par défaut au capteur capacitif S1, ce premier seuil de détection permettant de détecter le doigt 6 de l'utilisateur si ce dernier ne touche pas l'élément électriquement conducteur 5. Les moyens de traitement 7 comprennent également des moyens de contrôle du seuil de détection du capteur capacitif S1 configurés pour appliquer un deuxième seuil de détection au capteur capacitif S1 lorsque le signal issu du capteur capacitif supplémentaire S2 indique la présence du doigt 6 de l'utilisateur sur l'élément électriquement conducteur 5. Ce deuxième seuil de détection correspond à une plus forte sensibilité afin de détecter la présence du doigt 6 de l'utilisateur sur la touche de commande capacitive 3 malgré la capacité parasite produite au niveau du capteur capacitif S1 par le contact entre le doigt 6 et l'élément électriquement conducteur 5. Ainsi, le deuxième seuil de détection est déterminé à partir du changement de capacité produit par la présence d'un doigt 6 d'un utilisateur à la fois sur la touche de commande capacitive 3 et sur l'élément électriquement conducteur 5.

Selon le mode de réalisation représenté sur la figure 3, le module de commande 1 comprend une façade en polycarbonate 9 sur laquelle est fixée un film décoratif 11 du côté de la surface extérieure 2. Le film décoratif 11 est par exemple un film sur lequel sont fixés l'élément électriquement conducteur 5 et la touche de commande capacitive 3. Un film capacitif 13 comprenant les capteurs capacitifs S1 et S2 est fixé sur la face intérieure de la façade 9. La fixation du film décoratif 11 et du film capacitif 13 sur la façade est réalisée par exemple par collage.

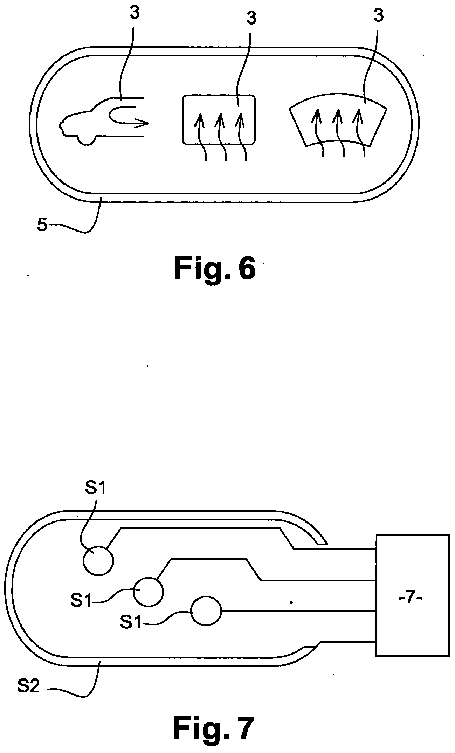

D'autre part, il est à noter que le nombre de touches de commande capacitives 3 n'est pas limité et que l'élément électriquement conducteur 5 peut prendre divers forme. La figure 4 représente un exemple de réalisation d'un module de commande 1 comprenant trois touches de commande capacitives 3 alignées horizontalement et un élément électriquement conducteur 5 de forme allongée et horizontale qui souligne la zone comprenant les touches capacitives. Dans ce cas, la capteur capacitif supplémentaire S2 doit pouvoir détecter un contact du doigt 6 de l'utilisateur sur toute la longueur de l'élément électriquement conducteur 5. Une telle détection est obtenue en adaptant la forme de l'électrode du capteur supplémentaire S2. La figure 5 représente un exemple de réalisation des capteurs S1 et S2 dans le cas du module de commande 1 de la figure 4. L'électrode du capteur S2 étant de forme allongée et horizontale comme l'élément électriquement conducteur 5. Selon un autre exemple de réalisation, l'élément électriquement conducteur 5 entoure les touches de commande capacitives 3 comme représenté sur la figure 6. Comme précédemment, la forme de l'électrode du capteur S2 peut être adaptée pour obtenir une détection d'un doigt 6 sur toute la surface de l'élément électriquement conducteur 5, l'électrode du capteur S2 est alors de la même forme que l'élément électriquement conducteur , c'est à dire de forme oblongue comme représenté sur la figure 7. Alternativement, plusieurs capteurs S2 peuvent être utilisés pour détecter la présence d'un doigt 6 sur l'ensemble de l'élément électriquement conducteur 5.

Ainsi, l'utilisation d'un capteur capacitif supplémentaire S2 permet de détecter la présence d'un doigt 6 d'un utilisateur sur un élément électriquement conducteur 5 situé à proximité d'une touche de commande capacitive 3 et d'ajuster le seuil de détection du capteur capacitif S1 associé à la touche de commande capacitive 3 afin de pouvoir détecter la présence du doigt 6 de l'utilisateur sur la touche de commande 3, qu'il touche simultanément l'élément électriquement conducteur 5 ou pas.

## Revendications

1. Module de commande (1) comprenant
- au moins un capteur capacitif (S1) configuré pour détecter un changement de capacité correspondant à un premier seuil de détection associé à la présence d'un doigt (6) d'un utilisateur dans une première zone prédéfinie correspondant à une touche de commande (3),
- un élément électriquement conducteur (5) situé dans une deuxième zone prédéfinie qui est distincte de la première zone prédéfinie et qui est dans un périmètre correspondant à la taille d'un doigt autour de la première zone,
**caractérisé en ce que** le module de commande (1) comprend également
- un capteur capacitif supplémentaire (S2) couplé à l'élément électriquement conducteur (5), configuré pour détecter la présence d'un doigt (6) d'un utilisateur sur l'élément électriquement conducteur (5),
- des moyens de contrôle du seuil de détection du, au moins un, capteur capacitif (S1) associé à une touche de commande (3) configurés pour appliquer un deuxième seuil de détection lorsqu'un doigt (6) d'un utilisateur est détecté sur l'élément électriquement conducteur (5) par le capteur capacitif supplémentaire (S2).

2. Module de commande (1) selon la revendication 1 dans lequel le deuxième seuil de détection est déterminé à partir du changement de capacité produit par la présence d'un doigt (6) d'un utilisateur à la fois sur la touche de commande (3) et sur l'élément électriquement conducteur (5).

3. Module de commande (1) selon la revendication 1 ou 2 dans lequel le deuxième seuil de détection correspond à une détection plus sensible que la détection fournie par le premier seuil de détection.

4. Module de commande (1) selon l'une des revendications précédentes dans lequel le module de commande (1) comprend au moins un premier et un deuxième capteurs capacitifs (S1) associés à une première et une deuxième zones de détection prédéfinies correspondant à une première et une deuxième touches de commande et dans lequel l'élément électriquement conducteur (5) est situé dans un périmètre correspondant à la taille d'un doigt autour de la première et de la deuxième zone de détection prédéfinie.

5. Module de commande (1) selon l'une des revendications précédentes dans lequel l'élément électriquement conducteur (5) comprend du chrome.

6. Module de commande (1) selon l'une des revendications précédentes dans lequel le module de commande (1) comprend un film extérieur (11) sur lequel est disposé l'élément électriquement conducteur (5) et sur lequel l'utilisateur pose le doigt (6) pour activer la, au moins une, touche de commande.

7. Module de commande (1) selon la revendication 6 dans lequel le film extérieur (1) est un film décoratif.

8. Module de commande (1) selon la revendication 6 ou 7 comprenant une façade en polycarbonate (9) et dans lequel le film extérieur (11) est fixé sur la face extérieure de ladite façade (9).

9. Module de commande (1) selon la revendication 7 dans lequel l'électrode du capteur capacitif (S1) associé à la, au moins une, touche de commande (3) et l'électrode du capteur capacitif supplémentaire (S2) sont disposées dans un film capacitif (13), ledit film capacitif (13) étant fixé sur la face intérieure de la façade (9).

10. Module de commande (1) selon la revendication 8 dans lequel la fixation du film extérieur (11) et du film capacitif (13) sur la façade (9) est réalisée par collage.

11. Module de commande (1) selon l'une des revendications précédentes dans lequel le module de commande (1) comprend un microcontrôleur connecté à l'électrode du capteur capacitif (S1) associé à la, au moins une, touche de commande (3) et à l'électrode du capteur capacitif supplémentaire (S2), le microcontrôleur étant configuré pour réaliser les mesures capacitives et comprenant les moyens de contrôle du seuil de détection du capteur capacitif (S1) associé à la, au moins une, touche de commande (3).

## Patentansprüche

1. Steuermodul (1), das enthält
- mindestens einen kapazitiven Sensor (S1), der konfiguriert ist, eine Kapazitätsänderung zu erfassen, die einer ersten Erfassungsschwelle entspricht, welche dem Vorhandensein eines Fingers (6) eines Benutzers in einer ersten vordefinierten Zone zugeordnet ist, die einer Steuertaste (3) entspricht,
- ein elektrisch leitendes Element (5), das sich in einer zweiten vordefinierten Zone befindet, die sich von der ersten vordefinierten Zone unterscheidet und die in einem Bereich entsprechend der Größe eines Fingers um die erste Zone liegt,
**dadurch gekennzeichnet, dass** das Steuermodul (1) ebenfalls enthält
- einen mit dem elektrisch leitenden Element (5) gekoppelten, zusätzlichen kapazitiven Sensor (S2), der konfiguriert ist, das Vorhandensein eines Fingers (6) eines Benutzers auf dem elektrisch leitenden Element (5) zu erfassen,
- Steuereinrichtungen der Erfassungsschwelle des mindestens einen einer Steuertaste (3) zugeordneten kapazitiven Sensors (S1), die konfiguriert sind, eine zweite Erfassungsschwelle anzuwenden, wenn ein Finger (6) eines Benutzers auf dem elektrisch leitenden Element (5) durch den zusätzlichen kapazitiven Sensor (S2) erfasst wird.

2. Steuermodul (1) nach Anspruch 1, wobei die zweite Erfassungsschwelle ausgehend von der durch das Vorhandensein eines Fingers (6) eines Benutzers sowohl auf der Steuertaste (3) als auch auf dem elektrisch leitenden Element (5) erzeugte Kapazitätsänderung bestimmt wird.

3. Steuermodul (1) nach Anspruch 1 oder 2, wobei die zweite Erfassungsschwelle einer empfindlicheren Erfassung als die von der ersten Erfassungsschwelle gelieferte Erfassung entspricht.

4. Steuermodul (1) nach einem der vorhergehenden Ansprüche, wobei das Steuermodul (1) mindestens einen ersten und einen zweiten kapazitiven Sensor (S1) enthält, die einer ersten und einer zweiten vordefinierten Erfassungszone zugeordnet sind, welche einer ersten und einer zweiten Steuertaste entsprechen, und wobei das elektrisch leitende Element (5) sich in einem der Größe eines Fingers um die erste und die zweite vordefinierte Erfassungszone herum entsprechenden Bereich befindet.

5. Steuermodul (1) nach einem der vorhergehenden Ansprüche, wobei das elektrisch leitende Element (5) Chrom enthält.

6. Steuermodul (1) nach einem der vorhergehenden Ansprüche, wobei das Steuermodul (1) eine Außenfolie (11) enthält, auf der das elektrisch leitende Element (5) angebracht ist und auf die der Benutzer den Finger (6) legt, um die mindestens eine Steuertaste zu betätigen.

7. Steuermodul (1) nach Anspruch 6, wobei die Außenfolie (11) eine dekorative Folie ist.

8. Steuermodul (1) nach Anspruch 6 oder 7, das eine Frontplatte aus Polycarbonat (9) enthält, und wobei die Außenfolie (11) an der Außenseite der Frontplatte (9) befestigt ist.

9. Steuermodul (1) nach Anspruch 7, wobei die Elektrode des der mindestens einen Steuertaste (3) zugeordneten kapazitiven Sensors (S1) und die Elektrode des zusätzlichen kapazitiven Sensors (S2) in einer kapazitiven Folie (13) angeordnet sind, wobei die kapazitive Folie (13) an der Innenseite der Frontplatte (9) befestigt ist.

10. Steuermodul (1) nach Anspruch 8, wobei die Befestigung der Außenfolie (11) und der kapazitiven Folie (13) an der Frontplatte (9) durch Kleben erfolgt.

11. Steuermodul (1) nach einem der vorhergehenden Ansprüche, wobei das Steuermodul (1) ein Mikrosteuergerät enthält, das mit der Elektrode des der mindestens einen Steuertaste (3) zugeordneten kapazitiven Sensors (S1) und mit der Elektrode des zusätzlichen kapazitiven Sensors (S2) verbunden ist, wobei das Mikrosteuergerät konfiguriert ist, die kapazitiven Messungen durchzuführen und die Steuereinrichtungen der Erfassungsschwelle des der mindestens einen Steuertaste (3) zugeordneten kapazitiven Sensors (S1) enthält.

## Claims

1. Control module (1) comprising
- at least one capacitive sensor (S1) configured to detect a change of capacitance corresponding to a first detection threshold associated with the presence of a finger (6) of a user in a first predefined area corresponding to a control key (3),
- an electrically conductive element (5) situated in a second predefined area which is distinct from the first predefined area and which is in a perimeter corresponding to the size of a finger around the first area,
**characterized in that** the control module (1) also comprises
- an additional capacitive sensor (S2) coupled to the electrically conductive element (5), configured to detect the presence of a finger (6) of a user on the electrically conductive element (5),
- means for controlling the detection threshold of the at least one capacitive sensor (S1) associated with a control key (3) configured to apply a second detection threshold when a finger (6) of a user is detected on the electrically conductive element (5) by the additional capacitive sensor (S2).

2. Control module (1) according to Claim 1, in which the second detection threshold is determined from the change of capacitance produced by the presence of a finger (6) of a user both on the control key (3) and on the electrically conductive element (5).

3. Control module (1) according to Claim 1 or 2, in which the second detection threshold corresponds to a more sensitive detection than the detection provided by the first detection threshold.

4. Control module (1) according to one of the preceding claims, in which the control module (1) comprises at least one first and at least one second capacitive sensors (S1) associated with a fist and a second predefined detection areas corresponding to a first and a second control keys, and in which the electrically conductive element (5) is situated in a perimeter corresponding to the size of a finger around the first and the second predefined detection areas.

5. Control module (1) according to one of the preceding claims, in which the electrically conductive element (5) comprises chromium.

6. Control module (1) according to one of the preceding claims, in which the control module (1) comprises an outer film (11) on which is arranged the electrically conductive element (5) and on which the user places the finger (6) to activate the at least one control key.

7. Control module (1) according to Claim 6, in which the outer film (11) is a decorative film.

8. Control module (1) according to Claim 6 or 7, comprising a polycarbonate front panel (9) and in which the outer film (11) is fixed onto the outer face of said front panel (9).

9. Control module (1) according to Claim 7, in which the electrode of the capacitive sensor (S1) associated with the at least one control key (3) and the electrode of the additional capacitive sensor (S2) are arranged in a capacitive film (13), said capacitive film (13) being fixed onto the inner face of the front panel (9).

10. Control module (1) according to Claim 8, in which the fixing of the outer film (11) and of the capacitive film (13) onto the front panel (9) is produced by bonding.

11. Control module (1) according to one of the preceding claims, in which the control module (1) comprises a microcontroller connected to the electrode of the capacitive sensor (S1) associated with the at least one control key (3) and to the electrode of the additional capacitive sensor (S2), the microcontroller being configured to produce the capacitive measurements and comprising the means for controlling the detection threshold of the capacitive sensor (S1) associated with the at least one control key (3).
